(19) Europäisches Patentamt

European Patent Office

Office européen des brevets

(11) EP 0 822 656 B1

(12) EUROPÄISCHE PATENTSCHRIFT

(45) Veröffentlichungstag und Bekanntmachung des Hinweises auf die Patenterteilung:
30.12.1998 Patentblatt 1998/53

(51) Int Cl.$^6$: H03F 3/00, H03G 1/00

(21) Anmeldenummer: 96112035.9

(22) Anmeldetag: 25.07.1996

(54) **Schaltungsanordnung mit einem Operationsverstärker**

Circuit arrangement with an operational amplifier

Montage de circuit avec un amplificateur opérationnel

(84) Benannte Vertragsstaaten:
AT CH DE DK ES FR GB IT LI NL

(43) Veröffentlichungstag der Anmeldung:
04.02.1998 Patentblatt 1998/06

(73) Patentinhaber:
• ENVEC Mess- und Regeltechnik GmbH + Co.
  79576 Weil am Rhein (DE)
• ENDRESS + HAUSER GMBH + CO.
  D-79689 Maulburg (DE)
• VEGA Grieshaber KG
  77709 Wolfach (DE)
• KAVLICO CORPORATION
  Moorpark, CA 93021 (US)

(72) Erfinder: **Seesink, Peter**
**5684 AG Best (NL)**

(74) Vertreter: **Morstadt, Volker, Dipl.-Ing.**
**Endress + Hauser**
**Zentrale Patentabteilung**
**Postfach 2222**
**79574 Weil am Rhein (DE)**

(56) Entgegenhaltungen:
EP-A- 0 146 355         FR-A- 2 674 706
GB-A- 2 053 598         US-A- 4 215 317

**Beschreibung**

Die Erfindung betrifft eine Schaltungsanordnung mit einem Operationsverstärker, die die Eigenschaft eines Verstärkers mit eingestellter bzw. einstellbarer nicht-invertierender Verstärkung hat.

Operationsverstärker sind bekanntlich auf dem Prinzip des Differenzverstärkers beruhende, als, insb. monolithisch, integrierte Halbleiter-Schaltungen realisierte Verstärker. Nach dem Fachbuch von U. Tietze und Ch. Schenk, "Halbleiter-Schaltungstechnik", Neunte Auflage, 1989, ISBN 3-540-19475-4, Seiten 132 bis 137 lassen sich mit einem Operationsverstärker durch die Widerstandsbeschaltung seiner beiden Eingänge und des Ausgangs entweder eine Schaltungsanordnung mit der Eigenschaft eines nicht-invertierenden Verstärkers oder eine Schaltungsanordnung mit der Eigenschaft eines invertierenden Verstärkers realisieren.

Beim invertierenden Verstärker der die Basis der Erfindungsgemäßen Schaltungsanordnung bildet, verbindet ein erster Widerstand mit dem Wert $r_1$ den Ausgang des Operationsverstärkers mit dessen invertierendem Eingang. Ferner liegt zwischen dem Eingang der Schaltungsanordnung und dem invertierenden Eingang des Operationsverstärkers ein zweiter Widerstand mit dem Wert $r_2$. Der gemeinsame Verbindungspunkt der beiden Widerstände ist also am invertierenden Eingang des Operationsverstärkers angeschlossen. Sein nicht-invertierender Eingang liegt am Schaltungsnullpunkt. Die Verstärkung v dieses invertierenden Verstärkers beträgt, wobei das Minuszeichen auf die Phasenverschiebung vo 180° zwischen Eingangs- und Ausgangssignal hinweist:

$$v = - r_1/r_2 \qquad (1)$$

Beim nicht-invertierenden Verstärker liegt dagegen am Ausgang des Operationsverstärkers ein erster Widerstand mit dem Wert $r_1'$. Zu diesem ist ein zweiter Widerstand mit dem Wert $r_2'$ in Serie geschaltet, der zum Schaltungsnullpunkt führt. Der gemeinsame Verbindungspunkt der beiden Widerstände ist am invertierenden Eingang des Operationsverstärkers angeschlossen, und sein Eingang ist mit dem des nicht-invertierenden Verstärkers identisch. Die Verstärkung v' dieses Verstärkers beträgt:

$$v' = 1 + r_1'/r_2', \qquad (2)$$

ist also positiv, was auf die Phasengleichheit zwischen Eingangs- und Ausgangssignal hinweist.

Gegenüber dem oben erläuterten invertierenden Verstärker hat der nicht-invertierende Verstärker den Nachteil, daß seine Verstärkung nur gleich oder größer als eins sein kann.

Werden auch die beiden Widerstände in eine oben erwähnte integrierte Halbleiter-Schaltung einbezogen, so ist es ferner schwierig, Werte der Verstärkung zwischen 1 und 1,25 zu erzielen, da hierfür ungünstige Werte der Widerstände erforderlich sind.

Bei diesen kleinen Verstärkungen tritt ferner ein weiterer Nachteil des nicht-invertierenden Verstärkers auf, der auf dessen Eigenschaft beruht, daß das jeweilige Potential der beiden Eingänge gleich der Eingangsspannung des Verstärkers ist. Somit muß jeder Eingang der Eingangsspannung folgen können, deren Maximalwert beträchtlich sein kann. Der demgegenüber vom Verstärker gerade noch verarbeitbare Eingangsspannungs-Bereich wird als dessen Eingangs-Gleichtaktbereich (im Englischen: Common Mode Input Range) bezeichnet.

Bei den genannten kleinen Verstärkungen lassen sich nun erforderliche große Werte des Eingangs-Gleichtaktbereichs, wenn überhaupt, nur schwer realisieren.

Da heutige integrierte Halbleiter-Schaltungen ferner häufig Digitalsignale verarbeitende Digital-Teilschaltungen mit einem einem ersten Referenz-Potential entsprechenden Digital-Schaltungsnullpunkt und Analogsignale verarbeitende Analog-Teilschaltungen mit einem einem zweiten Referenz-Potential entsprechenden Analog-Schaltungsnullpunkt umfassen, fließt beim nicht-invertierenden Verstärker der Strom im zweiten Widerstand zum Potential des Analog-Schaltungsnullpunkt.

Nur wenn dieser zum Haupt-Schaltungsnullpunkt der integrierten Halbleiter-Schaltung einen ausreichend niederen Serienwiderstand hat, verursacht der auch darin fließende Strom keine dem gewünschten Potential des Analog-Schaltungsnullpunkts überlagerte Störspannung. Der erforderliche niedere Serienwiderstand läßt sich aber wegen anderer einzuhaltender Bedingungen der integrierten Halbleiter-Schaltung oft nicht realisieren.

Die Erfindung dient daher der gemeinsamen Lösung dieser vier unterschiedlichen Problemkreise und besteht daher in einer Schaltungsanordnung mit einem Eingang, mit einem Ausgang, mit einem ersten Operationsverstärker und mit einem einen Strom-Eingang und einen Strom-Ausgang aufweisenden Stromkopierer, welche Schaltungsanordnung die Eigenschaft eines Verstärkers mit eingestellter bzw. einstellbarer nicht-invertierender Verstärkung hat, wobei

- der erste Operationsverstärker einen invertierenden und einen nicht-invertierenden Eingang sowie einen Ausgang aufweist, der auch ein Signal-Ausgang der Schaltungsanordnung ist,
- der nicht-invertierende Eingang an einem ersten Referenz-Potential liegt,
- der Ausgang über einen ersten Widerstand mit dem invertierenden Eingang verbunden ist,
- der Eingang der Schaltungsanordnung über einen zweiten Widerstand am Strom-Eingang des Stromkopierers liegt und

- der Strom-Ausgang des Stromkopierers mit dem invertierenden Eingang des ersten Operationsverstärkers verbunden ist, wobei der Stromkopierer den Eingangsstrom an seinen Ausgang spiegelt,
- der Ausgangsteil des Stromkopierers an einem zweiten Referenz-Potential angeschlossen ist und
- der Eingangsteil des Stromkopierers am ersten Referenz-Potential liegt.

Nach einer Ausgestaltung der Erfindung besteht der zweite Widerstand aus einem ersten und einem zweiten Teilwiderstand, die miteinander in Serie liegen, und es ist ein erster Schalter, der zwischen dem Strom-Eingang des Stromkopierers und dem ersten Teilwiderstand angeordnet ist, und ein zweiter Schalter vorgesehen, der zwischen dem Strom-Eingang und einem Verbindungspunkt der Teilwiderstände angeordnet ist.

Nach einer anderen Ausgestaltung der Erfindung enthält der Eingangsteil des Stromkopierers einen zweiten Operationsverstärker mit einem invertierenden und mit einem nicht-invertierenden Eingang sowie mit einem Ausgang, wobei

- der Ausgang der Strom-Eingang des Stromkopieres ist sowie am invertierenden Eingang liegt und
- der nicht-invertierende Eingang am ersten Referenz-Potential angeschlossen ist.

Nach einer weiteren Ausgestaltung der Erfindung enthält der Eingangsteil des Stromkopierers schließlich einen zweiten Operationsverstärker mit einem invertierenden und mit einem nicht-invertierenden Eingang sowie mit einem Ausgang, wobei

- der Ausgang der Strom-Eingang des Stromkopieres ist,
- der nicht-invertierende Eingang am ersten Referenz-Potential angeschlossen ist,
- zwischen dem Ausgang und dem invertierenden Eingand des zweiten Operationsverstärkers eine erste Serienschaltung des ersten und eines dritten Schalters sowie eine zweite Serienschaltung des zweiten und eines vierten Schalters angeschlossen sind,
- der erste Teilwiderstand zwischen dem Verbindungspunkt des ersten und des dritten Schalters und dem Verbindungspunkt des zweiten und des vierten Schalters liegt,
- der zweite Teilwiderstand zum Verbindungspunkt des zweiten und des vierten Schalters führt und
- entweder der erste und der dritte Schalter gleichzeitig geschlossen sind
- oder der zweite und der vierte Schalter gleichzeitig geschlossen sind und
- der Strom-Ausgang des Stromkopierers mit dem invertierenden Eingang des ersten Operationsverstärkers über einen dauernd geschlossenen Schalter verbunden ist.

Ein Vorteil der Erfindung besteht darin, daß, wenn der jeweilige Wert des ersten bzw. des zweiten Widerstands mit $R_1$ bzw. $R_2$ bezeichnet wird, die Verstärkung V des nicht-invertierenden Verstärkers der Erfindung gleich $R_1/R_2$ ist:

$$V = + R_1/R_2 \qquad (3)$$

Damit entfällt aber die aus der Eins in Gleichung (2) resultierende Beschränkung der Verstärkung auf Werte gleich oder größer als eins und es können auch Verstärkungswerte zwischen null und eins realisiert werden.

Ein weiterer Vorteil ist, daß nun ohne weiteres Verstärkungen zwischen 1 und 1,25 realisiert werden können. Auch ist kein an einem Schaltungsnullpunkt liegender Widerstand vorhanden, so daß darüber auch kein Strom fließt und somit das Potential des Analog-Schaltungsnullpunkts davon unbeeinflußt bleibt.

Die Erfindung und weitere Vorteile werden nun anhand von Ausführungsbeispielen näher erläutert, die in den Figuren der Zeichnung dargestellt sind.

Fig. 1    zeigt nach Art eines Blockschaltbilds das der Erfindung zugrunde liegende Prinzip,

Fig. 2    zeigt nach Art eines Blockschaltbilds eine Ausgestaltung der Erfindung,

Fig. 3    zeigt nach Art eines Blockschaltbilds eine andere Ausgestaltung, und

Fig. 4    zeigt das Schaltbild eines in CMOS-Technik realisierten Stromkopierers.

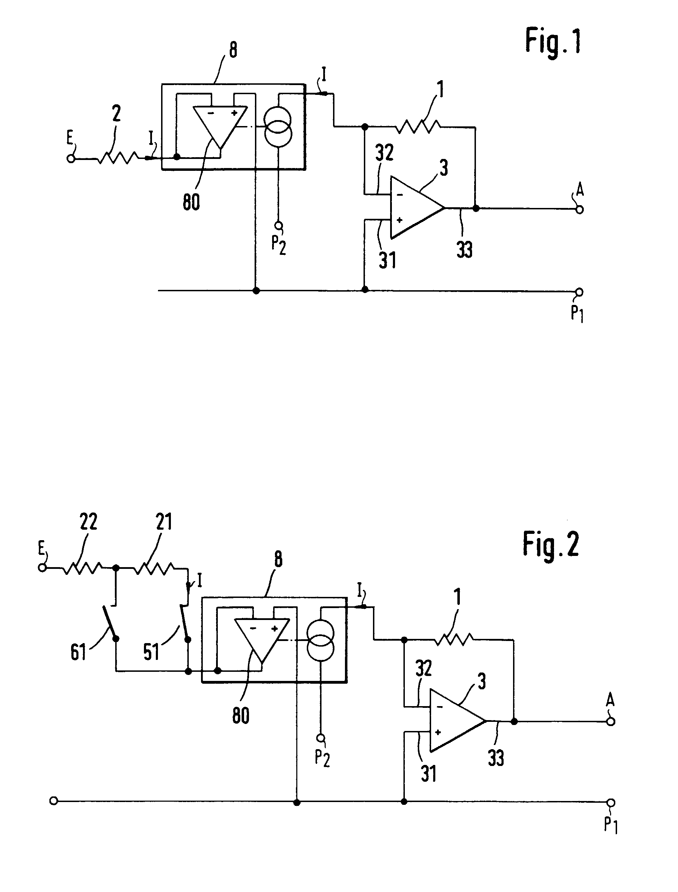

Im Blockschaltbild der Fig. 1 ist zur Erläuterung des der Erfindung zugrundeliegenden Prinzips die Schaltungsanordnung eines Verstärkers mit eingestellter bzw. einstellbarer nicht-invertierender Verstärkung V gezeigt. Die Schaltungsanordnung hat einen Eingang E und einen Ausgang A, so daß ein am Eingang E, bezogen auf ein erstes Referenz-Potentials $P_1$, liegendes Signal am Ausgang A, um die eingestellte Verstärkung V verstärkt, erscheint.

Wesentliche Teile des Verstärkers sind ein erster Operationsverstärker 3, ein einen Strom-Eingang und einen Strom-Ausgang aufweisender Stromkopierer 8, ein erster Widerstand 1 mit dem Widerstandswert $R_1$ und ein zweiter Widerstand 2 mit dem Widerstandswert $R_2$. Der Operationsverstärker 3 hat einen nicht-invertierenden Eingang 31, der in den Figuren, wie es bei Blockschaltbildern von Operationsverstärkern allgemein üblich ist, mit einem Pluszeichen versehen ist, und einen invertierenden Eingang 32, der in den Figuren mit einem Minuszeichen versehen. Der Ausgang 33 des Operationsverstärkers 3 ist zugleich der Ausgang A der Schaltungsanordnung. Der nicht-invertierende Eingang 31 liegt am ersten Referenz-Potential $P_1$.

Der Ausgang 33 ist über den ersten Widerstand 1 mit dem invertierenden Eingang 32 verbunden, der über einen dauernd geschlossenen Schalter 34 am Strom-Ausgang des Stromkopierers 8 liegt. Dessen Strom-Eingang ist über den zweiten Widerstand 2 am Eingang E der Schaltungsanordnung angeschlossen.

Ein Eingangsteil des Stromkopierers 8, der im Ausführungsbeispiel der Fig. 1 und 2 ein zweiter Operationsverstärker 80 ist, liegt am ersten Referenz-Potential $P_1$. Und zwar ist dies beim Operationsverstärker 80 dessen nicht-invertierender Eingang. Dessen invertierender Eingang und dessen Ausgang sind miteinander verbunden und der Strom-Eingang des Stromskopierers 8. Der Ausgangsteil des Stromkopierers 8 ist mit einem zweiten Referenz-Potential $P_2$ verbunden.

Ein durch den zweiten Widerstand 2 und in den Eingangskreis des Stromkopierers 8 hineinfließender Strom mit einem Stromstärke-Wert I erscheint in dessen Ausgangskreis entsprechend der wesentlichen Eigenschaft von Stromkopierern mit demselben Stromstärke-Wert I und fließt ebenfalls in dessen Ausgangskreis hinein, der Strom wird also "gespiegelt".

Da bei Operationsverstärkern der Eingangswiderstand idealerweise gleich unendlich ist, realerweise jedenfalls im Megohm-Bereich liegt, fließt der gespiegelte Strom mit dem Stromstärke-Wert I allein durch den ersten Widerstand 1. Somit gilt die obige Gleichung (3).

Bei der in Fig. 2 dargestellten Ausgestaltung der Erfindung ist der zweite Widerstand 2 nach Fig. 1 durch einen ersten und einen zweiten Teilwiderstand 21, 22 mit dem jeweiligen Widerstandswert $R_{21}$ bzw. $R_{22}$ ersetzt, die in Serie geschaltet sind. Ein erster Schalter 51 ist zwischen dem Strom-Eingang des Stromkopieres 80 und dem ersten Teilwiderstand 21 und ein zweiter Schalter 61 zwischen diesem Strom-Eingang und einem Verbindungspunkt der Teilwiderstände 21, 22 angeordnet.

Somit können durch entsprechendes Schließen des jeweiligen Schalters 51, 61 zwei verschiedene Werte der Verstärkung V eingestellt werden:

- Wenn Schalter 61 - wie gezeichnet - geöffnet und Schalter 51 - wie gezeichnet - geschlossen ist, ist die Summe $R_{21} + R_{22}$ der Widerstandswerte $R_{21}$, $R_{22}$ wirksam, und
- wenn Schalter 51 geöffnet und Schalter 61 geschlossen oder wenn beide Schalter 51, 61 geschlossen sind, ist nur der Widerstandswerte $R_{22}$ wirksam.

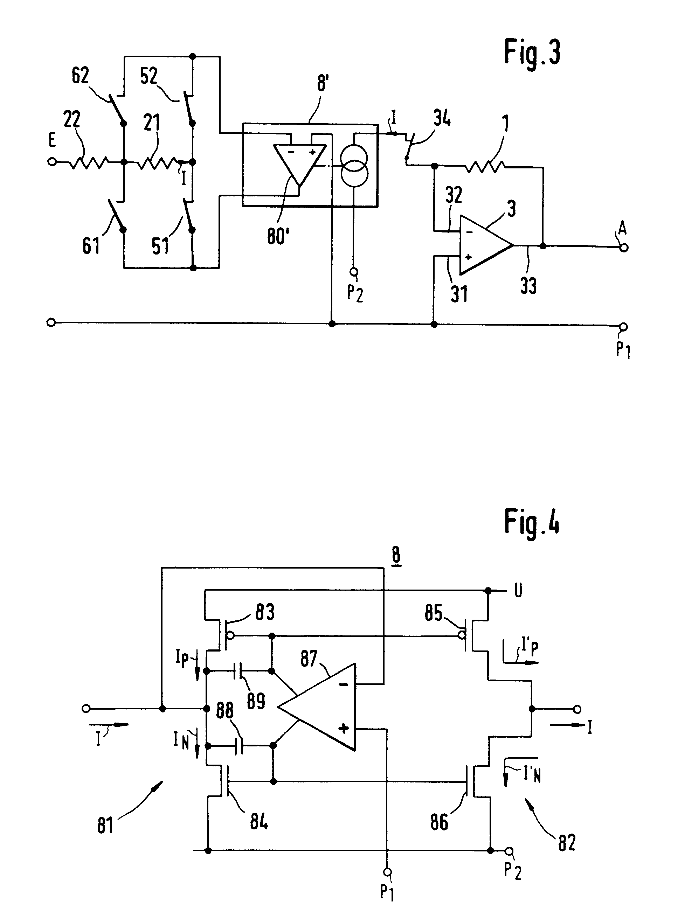

In Fig. 3 ist eine andere Ausgestaltung der Erfindung gezeigt, die dann günstiger ist als die Ausgestaltung nach Fig. 2, wenn nicht nur der Stromkopierer, sondern auch die Schalter 51, 61 Teil einer integrierten Halbleiter-Schaltung sein sollen. Dann sind die Schalter 51, 61 elektronische Schalter in Form von Transistoren, und deren jeweiliger Innen-Widerstand im leitenden Zustand, der sogenannte ON-Widerstand, ist spannungsabhängig und zudem nicht vernachlässigbar. Der ON-Widerstand addiert sich bei der Schaltungsanordnung nach Fig. 2 nämlich zu den Widerstandswerten $R_{21}$, $R_{22}$, da über die Schalter 51, 61 der Strom mit dem Stromstärke-Wert I fließt.

Die Schaltungsanordnung von Fig. 3 weist diesen Nachteil nicht auf. Zu diesem Zweck ist im Stromkopierer 8' zunächst die Verbindung zwischen dem invertierenden Eingang des zweiten Operationsverstärkers 80' und dessen Ausgang, wie sie in Fig. 2 vorhanden ist, aufgehoben, und der invertierende Eingang selbst ist beschaltet.

Hierzu ist zwischen dem Verbindungspunkt des Schalters 51 mit dem Teilwiderstand 21 und dem invertierenden Eingang des Operationsverstärkers 8o' ein weiterer Schalter 52 angeordnet. In vergleichbarer Weise liegt ein weiterer Schalter 62 zwischen diesem invertierenden Eingang und dem Verbindungspunkt der Teilwiderstände 21, 22. Die Schalter 51 und 52 bzw. 61 und 62 bilden somit eine erste bzw. eine zweite Serienschaltung von Schaltern. In jeder dieser Serienschaltungen müssen die Schalter gleichzeitig geschlossen oder geöffnet sein.

Durch entsprechendes Schließen der jeweiligen Schalter 51, 52 bzw. 61, 62 können wieder zwei verschiedene Werte der Verstärkung V eingestellt werden:

- Wenn die Schalter 61, 62 - wie gezeichnet - geöffnet und die Schalter 51, 52 - wie gezeichnet - geschlossen sind, ist die Summe $R_{21} + R_{22}$ der Widerstandswerte $R_{21}$, $R_{22}$ wirksam, und
- wenn die Schalter 51, 52 geöffnet und die Schalter 61, 62 geschlossen oder wenn alle vier Schalter geschlossen sind, ist nur der Widerstandswert $R_{22}$ wirksam.

Obwohl auch bei der Schaltungsanordnung von Fig. 3 im gezeichneten Zustand am ON-Widerstand des Schalters 51 ein vom darüber fließenden Strom mit dem Stromstärke-Wert I erzeugter Spannungsabfall vorhanden ist, kann dieser die am Verbindungspunkt des Schalters 51 mit dem Teilwiderstand 21 auftretende Spannung nicht nachteilig beeinflußen, da offensichtlich dieser Verbindungspunkt über den Schalter 52 virtuell mit dem ersten Referenz-Potential $P_1$ verbunden ist. Vergleichbares gilt, wenn die Schalter 61, 62 geschlossen sind. Dies trifft solange zu, wie der erwähnte Spannungsabfall die Ausgangsspannung des Operationsverstärkers 80' nicht begrenzt oder in die Sättigung steuert.

Um sicherzustellen, daß die jeweilige Spannung am Strom-Eingang bzw. am Strom-Ausgang des Stromkopierers 8' identisch sind, ist der dauernd geschlossene Schalter 34 vorgesehen, der den invertierenden Eingang 32 des ersten Operationsverstärkers 3 mit dem Strom-Ausgang des Stromkopierers 8' verbindet und natürlich ebenfalls durch ein Halbleiter-Bauelement realisiert ist wie die anderen Schalter.

Im Falle von Isolierschicht-Feldeffekt-Transistoren als Schaltern ist bei den die Schalter 34, 61, 62 realisierenden Feldeffekt-Transistoren das jeweilige Breite-zu-Länge-Verhältnis ihrer Gate-Elektroden, also das sogenannte W/L-Verhältnis, identisch zu machen.

Wenn der Teilwiderstand 21 einen ausreichend niedrigen Wert hat, können die weiteren Schalter 52, 62 weggelassen und der invertierende Eingang des Operationsverstärkers 80' am Verbindungspunkt des Teilwiderstands 21 mit dem Schalter 51 angeschlossen werden.

Sollen mehr als zwei Werte der Verstärkung einstellbar sein, so können der Serienschaltung der Teilwiderstände 21, 22 nach dem Vorbild der Fig. 2 und 3 selbstverständlich weitere Teilwiderstände hinzugefügt werden, denen dann entsprechende weitere Schalter zuzuordnen sind.

In Fig. 4 ist das Schaltbild eines Stromkopierers 8 gezeigt, der in der Technik der integrierten komplementären Isolierschicht-Anreicherungs-Feldeffekt-Transistoren, also in sogenannter CMOS-Technik, realisiert ist.

Im einzelnen zeigt das Schaltbild von Fig. 4 eine erste Serienschaltung 81 aus zwei zwischen einem Betriebspotential U und dem zweiten Referenz-Potential $P_2$, mit ihren gesteuerten Strompfaden in Serie geschaltet, liegenden Transistoren 83, 84, die von zueinander komplementärem Leitungstyp sind.

Ferner ist eine zweite Serienschaltung 82 aus zwei zwischen dem Betriebspotential U und dem zweiten Referenz-Potential $P_2$, mit ihren gesteuerten Strompfaden in Serie geschaltet, liegenden Transistoren 85, 86 vorhanden, die von zueinander komplementärem Leitungstyp sind; Transistor 83 bzw. 85 ist ein p-Kanal- und Transistor 84 bzw. 86 ein n-Kanal-Transistor. Die Steueranschlüsse der beiden Transistoren 83, 85 sind miteinander verbunden und ebenso die Steueranschlüsse der beiden Transistoren 84, 86.

Der Verbindungspunkt der gesteuerten Strompfade der Transistoren 83, 84 der ersten Serienschaltung 81 liegt am invertierenden Eingang eines weiteren Operationsverstärkers 87, dessen nicht-invertierender Eingang am ersten Referenz-Potential $P_1$ angeschlossen ist.

Der Operationsverstärkers 87 hat einen Differenzausgang, dessen einer Pol am Verbindungspunkt der Steueranschlüsse der beiden Transistoren 84, 86 und dessen anderer Pol am Verbindungspunkt der Steueranschlüsse der beiden Transistoren 83, 85 liegt.

Ferner ist jeder dieser Pole über je einen Kondensator 88 bzw. 89 mit dem Verbindungspunkt der gesteuerten Strompfade der Transistoren der ersten Serienschaltung 81 verbunden. In Abhängigkeit von der konkreten Innenschaltung des weiteren Operationsverstärkers 87 kann auch nur entweder der Kondensator 88 oder nur der Kondensator 89 vorgesehen werden.

In die Fig. 4 ist auch das Verhalten des Stromkopierers 8 hinsichtlich des Stroms mit dem Stromstärke-Wert I eingezeichnet. Dieser Strom teilt sich in einen im Transistor 83 fließenden "positiven" Strom $I_P$ und einen im Transistor 84 fließenden "negativen" Strom $I_N$ auf. In den Transistoren 85, 86 der zweiten Serienschaltung 82 fließen entsprechend gleiche - kopierte - Ströme $I'_P$ bzw. $I'_N$, die sich zum - kopierten - Strom mit dem Stromstärke-Wert I addieren.

Abschließend wird noch auf das Folgende hingewiesen: Üblicherweise werden integrierte Halbleiter-Schaltungen, die ausschließlich Digitalsignale verarbeiten, von einer Betriebsspannungsquelle gespeist, deren negativer Pol als Schaltungsnullpunkt dient und somit auch als Digital-Schaltungsnullpunkt bezeichnet werden kann. In Herstellerangaben werden das Potential dieses Digital-Schaltungsnullpunkts abgekürzt oft mit $V_{ss}$ und das positive Potential oft mit $V_{dd}$ oder $V_{cc}$ bezeichnet. Im übrigen ist eine Betriebsspannungsquelle, die auch eine gegenüber dem Digital-Schaltungsnullpunkt negative Spannung hat, nicht erforderlich. Ein heute weit verbreiteter und üblicher Wert $V_{dd}$ oder $V_{cc}$ der Betriebsspannung ist +5 V.

Da Analogsignale gegenüber einem Referenz-Potential, das als Analog-Schaltungsnullpunkt betrachtet werden kann, sowohl positive als auch negative Werte annehmen können, benötigen integrierte Halbleiter-Schaltungen, die Analogsignale verarbeiten, eine Betriebsspannungsquelle, die gegenüber diesem Analog-Schaltungsnullpunkt sowohl einen positiven als auch einen negativen Wert hat, also eine bipolare Betriebsspannungsquelle. Wenn nun das Referenz-Potential zu O V gewählt wird, ist das im wörtlichen Sinne der Analog-Schaltungs"nullpunkt". Dann müssen aber $V_{ss}$ z.B. den Wert -2,5 V und $V_{dd}$ oder $V_{cc}$ den Wert +2,5 V haben.

Für sowohl Analog- als auch Digitalsignale verarbeitende integrierte Halbleiter-Schaltungen, im folgenden als gemischte Schaltungen bezeichnet, bedeutet dies z.B., daß der Digital-Schaltungsnullpunkt ein Potential von $V_{ss}$ von -2,5 V hat, während der Analog-Schaltungsnullpunkt 0 V hat. Das macht aber die obige bipolare Betriebsspannungsquelle erforderlich. Um dies zu vermeiden, wird häufig bei gemischten Schaltungen der Analog-Schaltungsnullpunkt auf +2,5 V und der Digital-Schaltungs"nullpunkt" auf 0 V gelegt.

Da diese Wahl und die genannten Spannungs-Werte nicht zwingend sind, wurde oben verallgemeinernd von einem ersten und von einem zweiten Referenz-Potential $P_1$, $P_2$ gesprochen. Für die obigen Spannungswerte und deren Polaritäten entsprechen das erste bzw. das zweite Referenz-Potential $P_1$, $P_2$ jedenfalls dem genannten Analog-Schaltungsnullpunkt bzw. dem erläuterten Digital-Schaltungsnullpunkt.

**Patentansprüche**

1. Schaltungsanordnung mit einem Eingang (E), mit einem Ausgang (A), mit einem ersten Operationsverstärker (3) und mit einem einen Eingangsteil mit einem Strom-Eingang und einen Ausgangsteil mit einem Strom-Ausgang aufweisenden Stromkopierer (8, 8'), welche Schaltungsanordnung die Eigenschaft eines Verstärkers mit eingestellter bzw. einstellbarer nicht-invertierender Verstärkung hat, wobei

   - der erste Operationsverstärker (3) einen nicht-invertierenden und einen invertierenden Eingang (31, 32) sowie einen Ausgang (33) aufweist, der auch ein Signal-Ausgang (A) der Schaltungsanordnung ist,
   - der nicht-invertierende Eingang (31) an einem ersten Referenz-Potential ($P_1$) liegt,
   - der Ausgang (33) über einen ersten Widerstand (1) mit dem invertierenden Eingang (32) verbunden ist,
   - der Eingang (E) der Schaltungsanordnung über einen zweiten Widerstand (2) am Strom-Eingang des Stromkopierers (8) liegt,
   - der Strom-Ausgang des Stromkopierers mit dem invertierenden Eingang (32) des ersten Operationsverstärkers (3) verbunden ist, wobei der Stromkopierer den Eingangsstrom an seinen Ausgang spiegelt,
   - der Ausgangsteil des Stromkopierers an einem zweiten Referenz-Potential ($P_2$) angeschlossen ist und
   - der Eingangsteil des Stromkopierers am ersten Referenz-Potential ($P_1$) liegt.

2. Schaltungsanordnung nach Anspruch 1

   - mit einem aus einem ersten und einem zweiten Teilwiderstand (21, 22) bestehenden zweiten Widerstand, welche Teilwiderstände in Serie geschaltet sind,
   - mit einem ersten Schalter (51), der zwischen dem Strom-Eingang des Stromkopierers (8) und dem ersten Teilwiderstand (21) angeordnet ist, und
   - mit einem zweiten Schalter (61), der zwischen dem Strom-Eingang des Stromkopierers (8) und einem Verbindungspunkt der Teilwiderstände angeordnet ist.

3. Schaltungsanordnung nach Anspruch 1, bei der der Eingangsteil des Stromkopierers (8) einen zweiten Operationsverstärker (80) mit einem invertierenden und mit einem nicht-invertierenden Eingang sowie mit einem Ausgang enthält, wobei

   - der Ausgang der Strom-Eingang des Stromkopieres ist sowie am invertierenden Eingang liegt und
   - der nicht-invertierende Eingang am ersten Referenz-Potential ($P_1$) angeschlossen ist.

4. Schaltungsanordnung nach Anspruch 2, bei der der Eingangsteil des Stromkopierers (8') einen zweiten Operationsverstärker (80') mit einem invertierenden und mit einem nicht-invertierenden Eingang sowie mit einem Ausgang enthält, wobei

   - der Ausgang der Strom-Eingang des Stromkopieres ist,
   - der nicht-invertierende Eingang am ersten Referenz-Potential ($P_1$) angeschlossen ist,
   - zwischen dem Ausgang und dem invertierenden Eingang des zweiten Operationsverstärkers eine erste Serienschaltung des ersten und eines dritten, Schalters (51, 52) sowie eine zweite Serienschaltung des zweiten und eines vierten Schalters (61, 62) des zweiten und eines vierten Schalters (61, 62) angeschlossen sind,
   - der erste Teilwiderstand (21) zwischen dem Verbindungspunkt des resten und des dritten Schalters (51, 52) und dem Verbindungspunkt des zweiten und des vierten Schalters (61, 62) liegt,
   - der zweite Teilwiderstand (22) zum Verbindungspunkt des zweiten und des vierten Schalters (61, 62) führt,
   - entweder der erste und der dritte Schalter gleichzeitig geschlossen sind
   - oder der zweite und der vierte Schalter gleichzeitig geschlossen sind und
   - der Strom-Ausgang des Stromkopierers mit dem invertierenden Eingang (32) des ersten Operationsverstärkers (3) über einen dauernd geschlossenen Schalter (34) verbunden ist.,

**Claims**

1. A circuit arrangement with an input (E), with an output (A), with a first operational amplifier (3) and with a current copier (8, 8') which has a current input and a current output, which circuit arrangement has the property of an amplifier with a set or adjustable non-inverting gain,

   - the first operational amplifier (3) having an inverting and a non-inverting input (31, 32) as well as an output (33) which is also a signal output (A) of the circuit arrangement,
   - the non-inverting input (31) being connected to a first reference potential ($P_1$),
   - the output (33) being connected via a first resistor (1) to the inverting input (32),

- the input (E) of the circuit arrangement being connected via a second resistor (2) to the current input of the current copier (8), and
- the current output of the current copier (8) being connected to the inverting input (32) of the first operational amplifier (3), the current copier mirroring the input current to its output,
- the output section of the current copier being connected to a second reference potential (P$_2$), and
- the input section of the current copier being connected to the first reference potential (P$_1$).

2. A circuit arrangement as claimed in claim 1 wherein

- the second resistor consists of a first and a second partial resistor (21, 22), which are connected in series with one another, and
- a first switch (51), which is arranged between the current input of the current copier (8) and the first partial resistor (21), and
- a second switch (61) are present, which is arranged between the current input of the current copier (8) and a junction point of the partial resistors.

3. A circuit arrangement as claimed in claim 1 wherein the input section of the current copier (8) contains a second operational amplifier (80) having an inverting and having a non-inverting input as well as having an output,

- the output being the current input of the current copier and also being connected to the inverting input, and
- the non-inverting input being connected to the first reference potential (P$_1$).

4. A circuit arrangement as claimed in claim 2 wherein the input section of the current copier (8') contains a second operational amplifier (80') having an inverting and having a non-inverting input as well as having an output,

- the output being the current input of the current copier,
- the non-inverting input being connected to the first reference potential (P$_1$),
- a first series circuit formed by a first and a third switch (51, 52) as well as a second series circuit formed by a second and a fourth switch (61, 62) being connected between the output and the inverting input of the second operational amplifier,
- the first partial resistor (21) being connected between the junction point of the first and of the third switch (51, 52) and the junction point of the second and of the fourth switch (61, 62),

- the second partial resistor (22) leading to the junction point of the second and of the fourth switch (61, 62), and
- either the first and the third switch being simultaneously closed
- or the third and the fourth switch being simultaneously closed, and
- the current output of the current copier being connected to the inverting input (32) of the first operational amplifier (3) via a permanently closed switch (34).

**Revendications**

1. Montage de circuit comprenant une entrée (E), une sortie (A), un premier amplificateur opérationnel (3) et un suiveur de courant (8, 8') présentant un élément d'entrée avec une entrée de courant et un élément de sortie avec une sortie de courant, ce montage possèdant la propriété d'un amplificateur à gain réglé ou réglable non inverseur, dans lequel:

- le premier amplificateur opérationnel (3) présente une entrée non inverseuse et une entrée inverseuse (31, 32) ainsi qu'une sortie (33) servant également de sortie de signal (A) du montage,
- l'entrée non inverseuse (31) est connectée à un premier potentiel de référence (P$_1$),
- la sortie (33) est reliée à l'entrée inverseuse (32) par l'intermédiaire d'une première résistance (1),
- l'entrée (E) du montage de circuit est connectée à l'entrée de courant du suiveur de courant (8) par l'intermédiaire d'une deuxième résistance (2),
- la sortie de courant du suiveur de courant est reliée à l'entrée inverseuse (32) du premier amplificateur opérationnel (3), le suiveur de courant reproduisant le courant d'entrée à sa sortie,
- l'élément de sortie du suiveur de courant est relié à un deuxième potentiel de référence (P$_2$), et
- l'élément d'entrée du suiveur de courant est connecté au premier potentiel de référence (P$_1$).

2. Montage selon la revendication 1, comprenant

- une deuxième résistance constituée par une première et une deuxième résistances partielles (21, 22) montées en série,
- un premier interrupteur (51) disposé entre l'entrée de courant du suiveur de courant (8) et la première résistance partielle (21), et
- un deuxième interrupteur (61) disposé entre l'entrée de courant du suiveur de courant (8) et un point de liaison des résistances partielles.

3. Montage selon la revendication 1, dans lequel l'élément d'entrée du suiveur de courant (8) comprend un deuxième amplificateur opérationnel (80) avec une entrée inverseuse et une entrée non inverseuse ainsi qu'une sortie, et dans lequel

- la sortie est l'entrée de courant du suiveur de courant et est connectée à l'entrée inverseuse, et
- l'entrée non inverseuse est raccordée au premier potentiel de référence ($P_1$).

4. Montage selon la revendication 2, dans lequel l'élément d'entrée du suiveur de courant (8') comprend un deuxième amplificateur opérationnel (80') avec une entrée inverseuse et une entrée non inverseuse ainsi qu'une sortie, où

- la sortie est l'entrée de courant du suiveur de courant,
- l'entrée non inverseuse est raccordée au premier potentiel de référence ($P_1$),
- entre la sortie et l'entrée inverseuse du deuxième amplificateur opérationnel sont raccordés un premier circuit en série du premier et d'un troisième interrupteurs (51, 52) ainsi qu'un deuxième circuit en série du deuxième et d'un quatrième interrupteurs (61, 62),
- la première résistance partielle (21) est placée entre le point de liaison du premier et du troisième interrupteurs (51, 52) et le point de liaison du deuxième et du quatrième interrupteurs (61, 62),
- la deuxième résistance partielle (22) conduit au point de liaison entre le deuxième et le quatrième interrupteurs (61, 62),
- soit le premier et le troisième interrupteurs sont fermés simultanément,
- soit le deuxième et le quatrième interrupteurs sont fermés simultanément, et
- la sortie de courant du suiveur de courant est reliée à l'entrée inverseuse (32) du premier amplificateur opérationnel (3) par l'intermédiaire d'un interrupteur (34) fermé en permanence.

# Fig.1

# Fig.2

9

Fig.3

Fig.4